# EUROPEAN PATENT APPLICATION

(11) **EP 3 070 263 A1**
(43) Date of publication of application: **21.09.2016**
(21) Application number: 16160304.8
(22) Date of filing: 15.03.2016
(51) Int. Cl.: E21B 47/10

(54) **EFFICIENT SIMULATION OF OILFIELD PRODUCTION SYSTEMS**

(30) Priority: 17.03.2015 US 201514660003
(71) Applicant: Services Pétroliers Schlumberger, 75007 Paris (FR); Geoquest Systems B.V., 2586 BJ The Hague (NL)
(72) Inventor: BONETI, Carlos, Menlo Park, CA California 94025 (US); LESSARD, Rodney, Houston, TX Texas 77056 (US); SWAMINATHAN, Deepa, Sugar Land, TX Texas 77478 (US)
(74) Representative: Schlumberger Cambridge Research Limited

(57) **Abstract**

Systems and methods for simulating fluid properties in a production system include receiving data from a sensor. The data represents a first property of a fluid that is measured by the sensor. A second property of the fluid is estimated based at least in part on the measured first property. A third property of the fluid is calculated using the estimated second property. Calculating the third property includes running a first simulation on a first simulator and running a second simulation on a second simulator. The first and second simulations at least partially overlap in the time domain. It is then determined whether results of the first and second simulations converge to a common value.

## Description

### Background

Production systems provide transportation of fluids (e.g., oil and gas) from well locations to processing facilities. These production systems may include hundreds or thousands of pipelines or flowlines that are interconnected at manifolds to form a network. A user (e.g., a production engineer) may want to know the amount of fluid flowing through the system, the flow rate of the fluid through the system, the pressure of the fluid in the system, and the like. To obtain this information, the user may run simulations in the system. Each simulation is a complex problem that involves detailed multiphase flow science and engineering and mathematical methods to solve large systems of coupled equations.

Conventional simulations may calculate the properties of fluids in various flowlines in a sequential order. For example, the pressure of the fluid in a first flowline may be calculated, and the calculation of the pressure of the fluid in a second flowline may begin when the first calculation is complete. This results in long simulation times that may take days or even weeks to finish.

### Summary

A method for simulating fluid properties in a production system is disclosed. The method includes receiving data from a sensor. The data represents a first property of a fluid that is measured by the sensor. A second property of the fluid is estimated based at least in part on the measured first property. A third property of the fluid is calculated using the estimated second property. Calculating the third property includes running a first simulation on a first simulator and running a second simulation on a second simulator. The first and second simulations at least partially overlap in the time domain. It is then determined whether results of the first and second simulations converge to a common value.

The method also includes placing the first and second simulations in a queue.

The first and second simulations may be loaded into the first and second simulators in an order in which the first and second simulations are placed in the queue.

The first and second simulations may be loaded into the first and second simulators simultaneously.

The method also includes placing a third simulation in the queue, determining whether one of the simulators is available to run the third simulation, and running the third simulation on a next available simulator when it is determined that one of the plurality of simulators is available.

The method also includes modifying the estimate for the second property when the results for the first and second simulations do not converge to the common value.

The method also includes adjusting a setting of a pump or a compressor in response to the results.

The first property, the second property, and/or the third property may be selected from the group consisting of pressure, temperature, flow rate, and composition.

A non-transitory computer-readable medium is also disclosed. The non-transitory computer-readable medium stores instructions that, when executed by a processor of a computing system, cause the computing system to perform operations. The operations include receiving data from a sensor. The data represents a first property of a fluid that is measured by the sensor. A second property of the fluid is estimated based at least in part on the measured first property. A third property of the fluid is calculated using the estimated second property. Calculating the third property includes running a first simulation on a first simulator and running a second simulation on a second simulator. The first and second simulations at least partially overlap in the time domain. It is then determined whether results of the first and second simulations converge to a common value.

A computing system is also disclosed. The computer system includes a processor and a memory system including a non-transitory computer-readable medium storing instructions that, when executed by the processor, cause the computing system to perform operations. The operations include receiving data from a sensor. The data represents a first property of a fluid that is measured by the sensor. A second property of the fluid is estimated based at least in part on the measured first property. A third property of the fluid is calculated using the estimated second property. Calculating the third property includes running a first simulation on a first simulator and running a second simulation on a second simulator. The first and second simulations at least partially overlap in the time domain. It is then determined whether results of the first and second simulations converge to a common value.

It will be appreciated that this summary is intended merely to introduce some aspects of the present methods, systems, and media, which are more fully described and/or claimed below. Accordingly, this summary is not intended to be limiting.

### Brief Description of the Drawings

The accompanying drawings, which are incorporated in and constitute a part of this specification, illustrate embodiments of the present teachings and together with the description, serve to explain the principles of the present teachings. In the figures:
Figure 1 illustrates an example of a system that includes various management components to manage various aspects of a pipeline environment, according to an embodiment.
Figure 2 illustrates a schematic view of a production system including four wells, according to an embodiment.
Figure 3 illustrates a flow chart of a method for simulating fluid properties in the production system, according to an embodiment.
Figure 4 illustrates a flow chart of a portion of the method shown in Figure 3, according to an embodiment.
Figure 5 illustrates a schematic view of a gathering system for transporting fluid from a plurality of wells to a common point (e.g., a central processing facility), according to an embodiment.
Figure 6 illustrates a schematic view of a distribution system for transporting fluid from a well to a plurality of points, according to an embodiment.
Figure 7 illustrates a schematic view of a computing system for performing one or more of the methods disclosed herein, according to an embodiment.

### Detailed Description

The following detailed description refers to the accompanying drawings. Wherever convenient, the same reference numbers are used in the drawings and the following description to refer to the same or similar parts. While several embodiments and features of the present disclosure are described herein, modifications, adaptations, and other implementations are possible, without departing from the spirit and scope of the present disclosure.

The systems and methods disclosed herein may simulate production systems using multi-core processors or computer clusters. Two or more simulations may be conducted in parallel, which may provide up to an order of magnitude increase in simulation performance, affording the user (e.g., a production engineer) more time to explore design alternatives and optimization and failure scenarios.

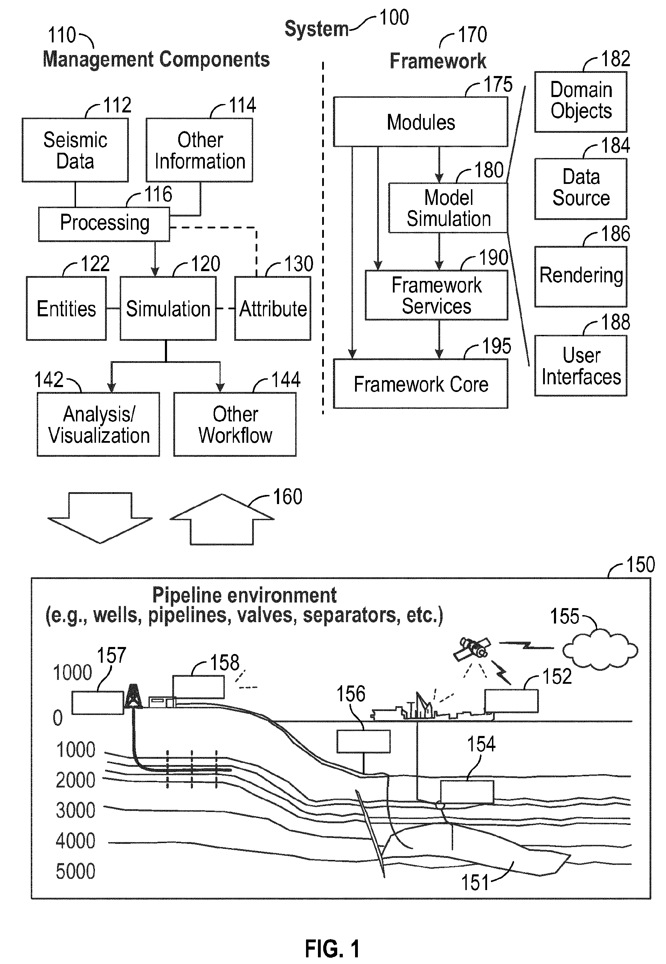

Figure 1 illustrates an example of a system 100 that includes various management components 110 to manage various aspects of a pipeline environment 150 (e.g., an environment that includes wells, transportation lines, risers, chokes, valves, separators, etc.). For example, the management components 110 may allow for direct or indirect management of design, operations, control, optimization, etc., with respect to the pipeline environment 150. In turn, further information about the pipeline environment 150 may become available as feedback 160 (e.g., optionally as input to one or more of the management components 110).

In the example of Figure 1, the management components 110 include a pipeline configuration component 112, an additional information component 114 (e.g., fluid measurement data), a processing component 116, a simulation component 120, an attribute component 130, an analysis/visualization component 142 and a workflow component 144. In operation, pipeline configuration data and other information provided per the components 112 and 114 may be input to the simulation component 120.

In an example embodiment, the simulation component 120 may rely on pipeline components or "entities" 122. The pipeline components 122 may include pipe structures and/or equipment. In the system 100, the components 122 can include virtual representations of actual physical components that are reconstructed for purposes of simulation. The components 122 may include components based on data acquired via sensing, observation, etc. (e.g., the pipeline configuration 112 and other information 114). An entity may be characterized by one or more properties (e.g., a pipeline model may be characterized by changes in pressure, heat transfer, pipe inclination and geometry, etc.). Such properties may represent one or more measurements (e.g., acquired data), calculations, etc.

In an example embodiment, the simulation component 120 may operate in conjunction with a software framework such as an object-based framework. In such a framework, entities may include entities based on pre-defined classes to facilitate modeling and simulation. A commercially available example of an object-based framework is the MICROSOFT^{®} .NET^{®} framework (Redmond, Washington), which provides a set of extensible object classes. In the .NET^{®} framework, an object class encapsulates a module of reusable code and associated data structures. Object classes can be used to instantiate object instances for use by a program, script, etc. For example, borehole classes may define objects for representing boreholes based on well data.

In the example of Figure 1, the simulation component 120 may process information to conform to one or more attributes specified by the attribute component 130, which may include a library of attributes. Such processing may occur prior to input to the simulation component 120 (e.g., consider the processing component 116). As an example, the simulation component 120 may perform operations on input information based on one or more attributes specified by the attribute component 130. In an example embodiment, the simulation component 120 may construct one or more models of the pipeline environment 150, which may be relied on to simulate behavior of the pipeline environment 150 (e.g., responsive to one or more acts, whether natural or artificial). In the example of Figure 1, the analysis/visualization component 142 may allow for interaction with a model or model-based results (e.g., simulation results, etc.). As an example, output from the simulation component 120 may be input to one or more other workflows, as indicated by a workflow component 144.

As an example, the simulation component 120 may include one or more features of a simulator such as a simulator provided in OLGA^{®} (Schlumberger Limited, Houston Texas. Further, in an example embodiment, the management components 110 may include features of a commercially available framework such as the PETREL^{®} seismic to simulation software framework (Schlumberger Limited, Houston, Texas). The PETREL^{®} framework provides components that allow for optimization of exploration and development operations. The PETREL^{®} framework includes seismic to simulation software components that can output information for use in increasing reservoir performance, for example, by improving asset team productivity. Through use of such a framework, various professionals (e.g., geophysicists, geologists, pipeline engineers, and reservoir engineers) can develop collaborative workflows and integrate operations to streamline processes. Such a framework may be considered an application and may be considered a data-driven application (e.g., where data is input for purposes of modeling, simulating, etc.).

In an example embodiment, various aspects of the management components 110 may include add-ons or plug-ins that operate according to specifications of a framework environment. For example, a commercially available framework environment marketed as the OCEAN^{®} framework environment (Schlumberger Limited, Houston, Texas) allows for integration of add-ons (or plug-ins) into a PETREL^{®} framework workflow. The OCEAN^{®} framework environment leverages .NET^{®} tools (Microsoft Corporation, Redmond, Washington) and offers stable, user-friendly interfaces for efficient development. In an example embodiment, various components may be implemented as add-ons (or plug-ins) that conform to and operate according to specifications of a framework environment (e.g., according to application programming interface (API) specifications, etc.).

Figure 1 also shows an example of a framework 170 that includes a model simulation layer 180 along with a framework services layer 190, a framework core layer 195 and a modules layer 175. The framework 170 may include the commercially-available OCEAN^{®} framework where the model simulation layer 180 is the commercially-available PETREL^{®} model-centric software package that hosts OCEAN^{®} framework applications. In an example embodiment, the PETREL^{®} software may be considered a data-driven application. The PETREL^{®} software can include a framework for model building and visualization.

As an example, a framework may include features for implementing one or more mesh generation techniques. For example, a framework may include an input component for receipt of information from interpretation of pipeline configuration, one or more attributes based at least in part on pipeline configuration, log data, image data, etc. Such a framework may include a mesh generation component that processes input information, optionally in conjunction with other information, to generate a mesh.

In the example of Figure 1, the model simulation layer 180 may provide domain objects 182, act as a data source 184, provide for rendering 186 and provide for various user interfaces 188. Rendering 186 may provide a graphical environment in which applications can display their data while the user interfaces 188 may provide a common look and feel for application user interface components.

As an example, the domain objects 182 can include entity objects, property objects and optionally other objects. Entity objects may be used to geometrically represent wells, surfaces, bodies, reservoirs, etc., while property objects may be used to provide property values as well as data versions and display parameters. For example, an entity object may represent a well where a property object provides log information as well as version information and display information (e.g., to display the well as part of a model).

In the example of Figure 1, data may be stored in one or more data sources (or data stores, generally physical data storage devices), which may be at the same or different physical sites and accessible via one or more networks. The model simulation layer 180 may be configured to model projects. As such, a particular project may be stored where stored project information may include inputs, models, results and cases. Thus, upon completion of a modeling session, a user may store a project. At a later time, the project can be accessed and restored using the model simulation layer 180, which can recreate instances of the relevant domain objects.

In the example of Figure 1, the pipeline environment 150 may be outfitted with any of a variety of sensors, detectors, actuators, etc. For example, equipment 152 may include communication circuitry to receive and to transmit information with respect to one or more networks 155. Such information may include information associated with downhole equipment 154, which may be equipment to acquire information, to assist with resource recovery, etc. Such equipment may include storage and communication circuitry to store and to communicate data, instructions, etc. As an example, one or more satellites may be provided for purposes of communications, data acquisition, etc. For example, Figure 1 shows a satellite in communication with the network 155 that may be configured for communications, noting that the satellite may additionally or alternatively include circuitry for imagery (e.g., spatial, spectral, temporal, radiometric, etc.).

Figure 1 also shows the geologic environment 150 as optionally including equipment 157 and 158 associated with a well. As an example, the equipment 157 and/or 158 may include components, a system, systems, etc. for pipeline condition monitoring, sensing, valve modulation, pump control, analysis of pipeline data, assessment of one or more pipelines 156, etc. The pipelines 156 may include at least a portion of the well, and may form part of, or be representative of, a network of pipes which may transport a production fluid (e.g., hydrocarbon) from one location to another.

As mentioned, the system 100 may be used to perform one or more workflows. A workflow may be a process that includes a number of worksteps. A workstep may operate on data, for example, to create new data, to update existing data, etc. As an example, a workstep may operate on one or more inputs and create one or more results, for example, based on one or more algorithms. As an example, a system may include a workflow editor for creation, editing, executing, etc. of a workflow. In such an example, the workflow editor may provide for selection of one or more pre-defined worksteps, one or more customized worksteps, etc. As an example, a workflow may be a workflow implementable in the PETREL^{®} software, for example, that operates on pipeline configuration, seismic attribute(s), etc. As an example, a workflow may be a process implementable in the OCEAN^{®} framework. As an example, a workflow may include one or more worksteps that access a module such as a plug-in (e.g., external executable code, etc.).

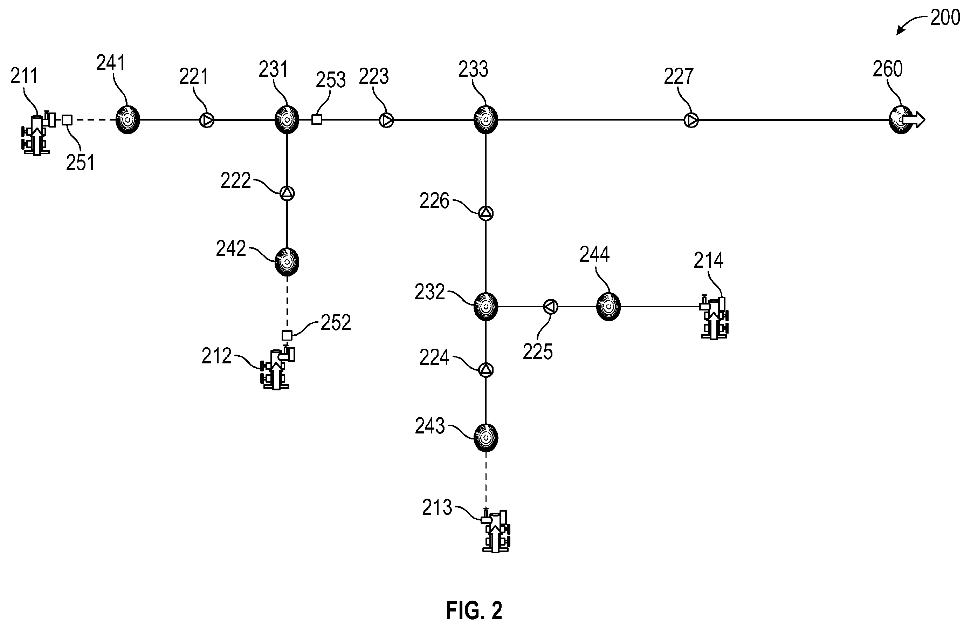

Figure 2 illustrates a schematic view of a production system 200 including one or more wells (four are shown: 211-214), according to an embodiment. The system 200 is designed to transport fluids from the wells 211-214 through a plurality of pipelines or flowlines 221-227 to a processing facility 260. Two or more flowlines (e.g., flowlines 221, 222) may intersect at a junction or manifold (three are shown: 231-233) where the fluid in the flowlines 221, 222 is combined into a single outlet flowline (e.g., flowline 223). One or more of the flowlines 221-227 may also include a "node" (four are shown: 241-244). The nodes 241-244 may represent a reporting location where the simulator may report *in situ* conditions such as pressure, volume, and mass flowrate.

Production equipment (e.g., pumps, compressors, etc.) may be in fluid communication with the fluid in the flowlines 221-227 to modify one or more properties of the fluid such as flow rate, pressure, temperature, composition, and the like. For example, the production equipment may be positioned in or proximate to the wells 211-214, the manifolds 231-233, or the nodes 241-244.

A plurality of sensors (three are shown: 251-253) may also be in fluid communication with the fluid in the flowlines 221-227 to measure one or more of the properties of the fluids (e.g., flow rate, pressure, temperature, composition). The sensors 251-253 may be positioned in or proximate to the wells 211-214, the manifolds 231-233, and/or the nodes 241-244. For example, the sensors 251-253 may be positioned proximate to the inlets and/or the outlets of the wells 211-214, the manifolds 231-233, or the nodes 241-244, as the properties of the fluid may change between a corresponding inlet and outlet due to the presence of production equipment positioned therebetween.

While the sensors 251-253 may be able to measure some of the properties of the fluid at locations where the sensors 251-253 are located, the sensors 251-253 may be unable to measure the properties of the fluids at different locations and/or other properties of the fluids. For example, the sensors 251-253 may be able to measure the pressures of the fluids where the sensors 251-253 are located but not in other locations. In another example, the sensors 251-253 may be able to measure the pressures of the fluids where the sensors 251-253 are located but unable to measure the flow rates of the fluids at those (or other) locations. In another example, the sensors 251-253 may be able to measure the flow rates of the fluids where the sensors 251-253 are located but not in other locations. In yet another example, the sensors 251-253 may be able to measure the flow rates of the fluids where the sensors 251-253 are located but unable to measure the pressures of the fluids at those (or other) locations. The sensors 251-253 may also be able to measure temperatures of the fluid, fractions of the volume of the fluid containing liquid and gas, and the like.

As such, the system 200 may be simulated to predict the same properties of the fluids that are measured by the sensors 251-253 but at different locations in the system 200 and/or to predict different properties of the fluids (i.e., types of properties not measured by the sensors 251-253). With knowledge of where the fluid enters and exits the system 200, the properties of the fluids measured by the sensors 251-253, and the physical environment between those points (e.g., geographical location, elevation, temperature, etc.), the system 200 may be simulated to predict properties of the fluids in the system 200. This information may enable the user to design the system 200 to meet business and regulatory requirements while working within the operational limits of the system 200.

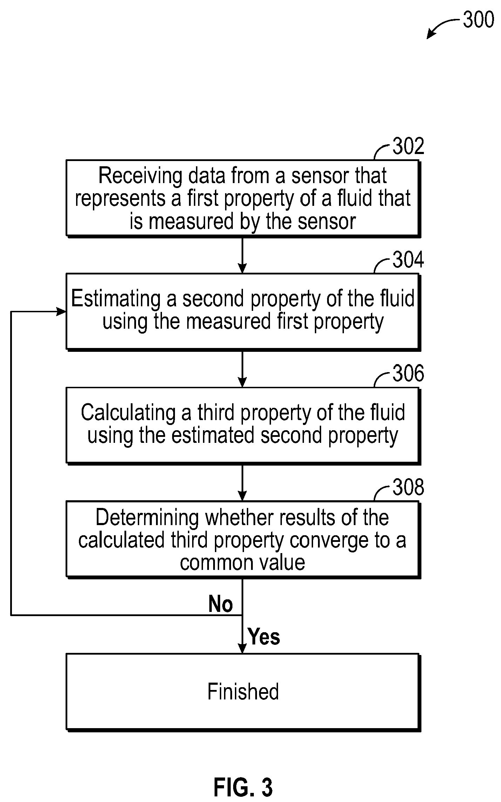

Figure 3 illustrates a flow chart of a method 300 for simulating fluid properties in the production system 200, according to an embodiment. The method 300 may begin by receiving data from one or more sensors 251-253 that represents one or more first properties of the fluid measured by the sensors 251-253 at one or more points in the system 200, as at 302. The measured first property may be, for example, a pressure of the fluid at the wells 211, 212 and the manifold 231. In other embodiments, the measured first property may be the mass of the fluid, the fraction of the volume of the fluid that is a liquid or gas, the flow rate of the fluid, pressures at different flow rates, and the like.

A second property of the fluid may then be estimated at one or more points in the system 200 using the first property, as at 304. The second property may be the same type of property as the first property but at a different location in the system 200. In another embodiment, the second property may be a different type of property than the first property. For example, the user may estimate that the liquid flow rate of the fluid flowing out of the first well 211 (and in the first flowline 221) is 1000 bbls/day, and the liquid flow rate of the fluid flowing out of the second well 212 (and in the second flowline 222) is 2000 bbls/day. As will be appreciated, the second property, and the locations (e.g., flowlines) in which it is estimated, may vary.

Next, a third property of the fluid may be calculated using the estimated second property, as at 306. The third property may be the same type of property as the second property and at the same location as the second property, or the third property may be the same type of property as the second property but at a different location in the system 200. In another embodiment, the third property may be a different type of property than the second property. In this example, the third property is the pressure of the fluid at the outlet of the first manifold 231 or in the flowline 223. As will be appreciated, the third property, and the locations in which it is calculated, may vary.

In this example, the third property may be calculated by running two simulations, as there are two flowlines 221, 222 that feed into the first manifold 231 and affect the pressure of the fluid at the outlet thereof. The first simulation may use the measured first property (e.g., the pressure of the fluid measured by the sensor 251) in combination with the estimated second property (e.g., the liquid flow rate of the fluid flowing out of the first well 211) to calculate the third property (e.g., the pressure of the fluid at the outlet of the first manifold 231). The first simulation may output a first result for the third property, which may be, for example, 200 pounds/inch² at the outlet of the first manifold 231.

The second simulation may use the measured first property (e.g., the pressure of the fluid measured by the sensor 252) in combination with the estimated second property (e.g., the liquid flow rate of the fluid flowing out of the second well 212) to calculate the third property (e.g., the pressure of the fluid at the outlet of the first manifold 231). The second simulation may output a second result for the third property, which may be, for example, 300 pounds/inch² at the outlet of the first manifold 231. As described in more detail below, the first and second simulations may at least partially overlap in the time domain. The first and second simulations may occur either synchronously or asynchronously. For example, the second simulation may begin at the same time as the first simulation, or after the first simulation begins but before the first simulation is complete. Thus, the simulations may be run in parallel.

Once the results for the third property are calculated in the different simulations, the results may be compared to determine whether they converged to a common value, as at 308. If the results of the simulations have converged to a common value, then the estimated second property and the calculated third property are determined to be substantially accurate. In this example, however, the results of the two simulations are different, which indicates that the estimated second property and the calculated third property may not be accurate. When this occurs, a different estimate may be generated for the second property, at 304, and the third property may be calculated again using the new estimate. This process may occur until the results of the simulations converge to a common value, indicating that the estimated second property and the calculated third property are substantially accurate.

A setting of a piece of production equipment in the system 200 may be adjusted in response to the results. This may change the first property of the fluid, the second property of the fluid, the third property of the fluid, or a combination thereof. In another embodiment, this may change a property of the fluid at a location different from where the first property is measured, the second property is estimated, and/or the third property is calculated. For example, adjusting the production equipment in this example may change the pressure and/or liquid flow rate of the fluid proximate to the central processing facility 260.

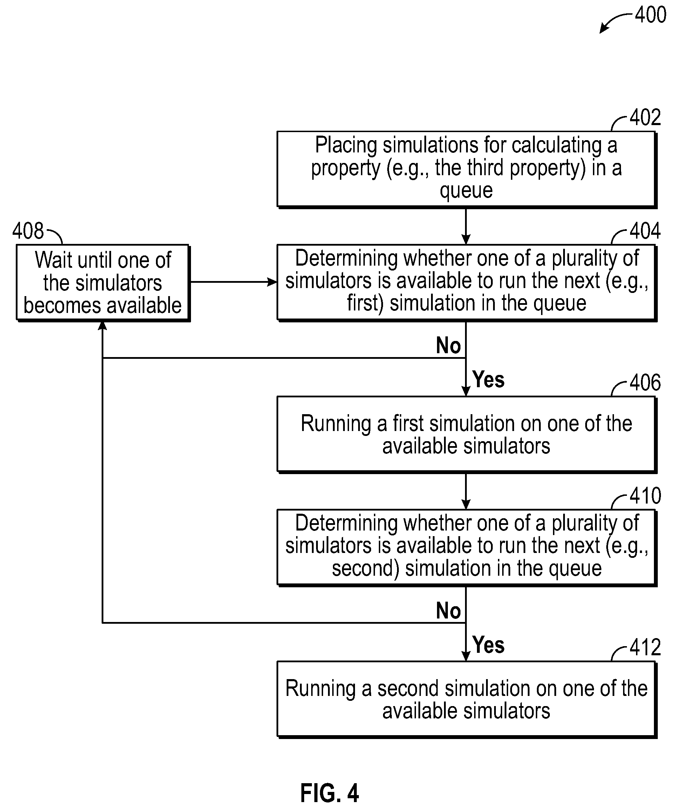

Figure 4 illustrates a flow chart of a portion of the method 300 shown in Figure 3, according to an embodiment. More particularly, Figure 4 illustrates a flow chart of a method 400 showing how the third property may be calculated (e.g., in block 306 of Figure 3). The simulations for calculating the third property may be placed in a queue, as at 402. This may be done in an asynchronous manner. In the example above, two simulations were used to calculate the third property. This, however, is a simple example. As will be appreciated, in other embodiments, the system 200 may include hundreds or even thousands of wells, manifolds, and nodes, which would result in some of the properties that are being calculated involving far more simulations. Thus, to better illustrate the method 400, the example will now be expanded to include ten simulations for calculating the third property.

A plurality of simulators may be available to run the different simulations. The number of simulators may range from about 2 to about 5, about 5 to about 10, about 10 to about 20, or more. In this example, there may be three simulators. Once the simulations for calculating the third property are placed in the queue, it may be determined whether there is a simulator available to run the next simulation in the queue, as at 404. Thus, in the beginning, there may be ten simulations and three simulators. It may be determined that there is a simulator (e.g., the first simulator) available to run the first of the ten simulations. The first simulator may begin running the first simulation, as at 406. If there is not a simulator available to run the first simulation (e.g., because each of the simulators is in use), then the process may wait until one of the simulators becomes available, as at 408.

Next, it may be determined whether there is a simulator (e.g., the second simulator) available to run the second of the ten simulations, as at 410. As there is a simulator available in this example, the second simulator may begin running the second simulation, as at 412. In one embodiment, this determination may occur simultaneously with the determination for the first simulation, and the first and second simulations may be run simultaneously (or at least partially overlap in the time domain) on the first and second simulators, respectively. In another embodiment, this determination may occur while the first simulator is running the first simulation, and the second simulation may begin while the first simulation is already running. If there is not a simulator available to run the second simulation (e.g., because each of the simulators is in use), then the process may wait until one of the simulators becomes available, as at 408.

Next, it may be determined whether there is a simulator (e.g., the third simulator) available to run the third of the ten simulations, and the third simulator may begin running the third simulation. In one embodiment, this determination may occur simultaneously with the determination for the first simulation and/or the second simulation, and the first, second, and third simulations may be run simultaneously on the first, second, and third simulators, respectively. In another embodiment, this determination may occur while the first simulator is running the first simulation and/or while the second simulator is running the second simulation.

Next, it may be determined whether there is a simulator available to run the fourth of the ten simulations. In this example, each of the three simulators is in use, and there is not currently a simulator available. As such, the fourth of the ten simulations may remain at the top/front of the queue and wait until one of the first three simulations finishes. As soon as one of the simulators finishes one of the first three simulations, then the fourth simulation may be run in that available simulator.

This process may continue until each of the ten simulations is run. Once each of the ten simulations is run, it may be determined whether the results from the simulations converge to a common value. If not, different estimates may be generated for the second properties, and the simulations may be re-run until the results for the third property converge to a common value.

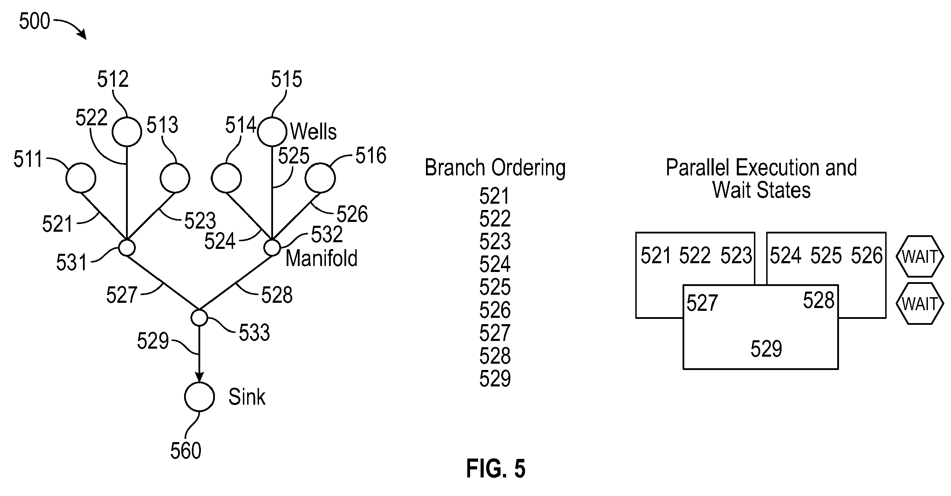

Figure 5 illustrates a schematic view of a gathering system 500 for transporting fluid from a plurality of wells (six are shown: 511-516) to a common point (e.g., a processing facility 560), according to an embodiment. The gathering system 500 is designed to transport fluids from the wells 511-516 through a plurality of flowlines 521-529 to the processing facility 560. Two or more flowlines may intersect at a manifold (three are shown: 531-533) where the fluid in the flowlines is combined into a single outlet flowline.

To calculate a property of the fluid at or near the inlet of the processing facility 560, simulations may first occur for the flowlines 521-526 between the wells 511-516 and the first two manifolds 531, 532, for the flowlines 527, 528 between the first two manifolds 531, 532 and the third manifold 533, and for the flowline 529 between the third manifold 533 and the processing facility 560. More particularly, using the methods 300, 400 described above, simulations may be performed on the flowlines 521-523 to calculate a property (e.g., pressure) at the first manifold 531. Similarly, simulations may be performed on the flowlines 524-526 to calculate a property (e.g., pressure) at the second manifold 532.

The simulations for the flowlines 521-526 may be placed in the queue. In at least one embodiment, the simulations for the flowlines 521-526 may be placed in the queue simultaneously. In another embodiment, the simulations for the flowlines 521-523 feeding the first manifold 531 may be positioned ahead (in the queue) of the simulations for the flowlines 524-526 feeding the second manifold 532. If, for example, there are three simulators, then the simulations for the flowlines 521-523 feeding the first manifold 531 may be run while the simulations for the flowlines 524-526 feeding the second manifold 532 remain in the queue waiting for the next available simulator. If, for example, there are four simulators, then the simulations for the flowlines 521-524 may be run while the simulations for the flowlines 525, 526 remain in the queue. The simulators may each run at the same time. Once one of the simulations is complete, the next simulation in the queue may start running in the now-available simulator.

Once the simulations for the flowlines 521-526 are complete, these results may be used as input data to run the simulation for the flowline 527 between the first and third manifolds 531, 533. Thus, the simulation for the flowline 527 between the first and third manifolds 531, 533 may be now added to the queue. Similarly, once the simulations for the flowlines 524-526 are complete, these results may be used as input data to run the simulation for the flowline 528 between the second and third manifolds 532, 533. Thus, the simulation for the flowline 528 between the second and third manifolds 532, 533 may now be added to the queue. Then, once the simulations for the flowlines 527, 528 have completed, these results may be used as input data to run the simulation for the flowline 529 between the third manifold 533 and the processing facility 560. Thus, this simulation may now be added to the queue.

Once the simulations for the flowlines 521-529 have completed, then it may be determined whether the results have converged. If the results have not converged, then the system 500 may be simulated again at a modified solution value. The result of this simulation may yield the desired property at or near the inlet of the processing facility 560.

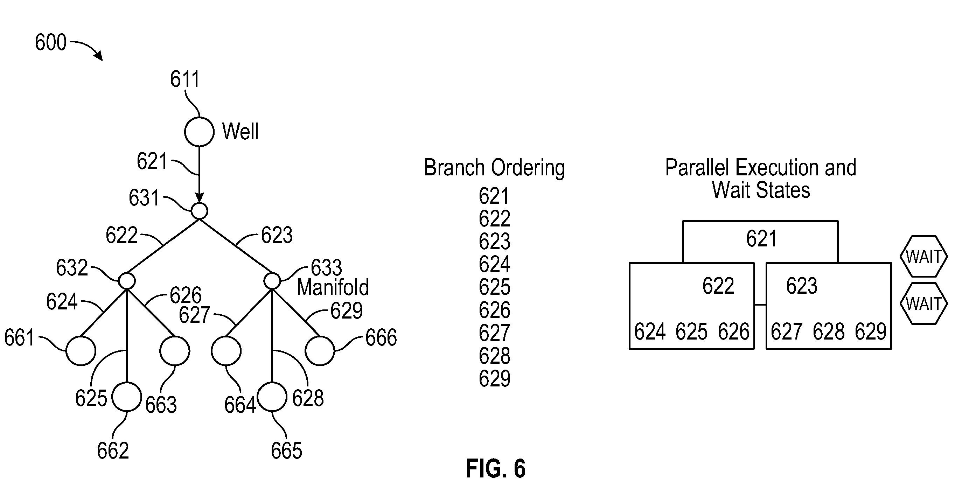

Figure 6 illustrates a schematic view of a distribution system 600 for transporting fluid from a well 611 to a plurality of points (six are shown: 661-666), according to an embodiment. The distribution system 600 is designed to transport fluids from the well 511 through a plurality of flowlines 621-629 to the points 661-666. Two or more flowlines may intersect at a manifold (three are shown: 631-633) where the fluid in the flowlines is combined into a single outlet flowline.

To calculate a property of the fluid at or near the inlets of the points 661-666, simulations may first occur for the flowline 621 between the well 611 and the first manifold 631, for the flowlines 622, 623 between the first manifold 631 and the second and third manifolds 632, 633, and for the flowlines 624-629 between the third manifold 633 and the points 661-666. More particularly, using the methods 300, 400 described above, an initial simulation may be performed on the flowline 621 to calculate a property (e.g., pressure) at the first manifold 631.

The simulation for the flowline 621 may be placed in the queue. This simulation may run on one simulator while the other simulators remain idle. Once the simulation for the flowline 621 is complete, this result may be used as input data to run the simulations for the flowlines 622, 623 between the first manifold 631 and the second and third manifolds 632, 633. Thus, the simulations for these flowlines 622, 623 may now be added to the queue. These simulations may run on two of the simulators while the other simulator(s) remain idle.

Then, once the simulation for the flowline 622 has completed, this result may be used as input data to run the simulations for the flowlines 624-626 between the second manifold 632 and the points 661-663. Thus, these simulations may now be added to the queue. Similarly, once the simulation for the flowline 623 has completed, this result may be used as input data to run the simulations for the flowlines 627-629 between the third manifold 633 and the points 664-666. Thus, these simulations may now be added to the queue.

The simulations for the flowlines 624-629 may be placed in the queue in the order that their corresponding input data becomes available. For example, the simulations for the flowlines 627-629 from the third manifold 633 may be positioned ahead (in the queue) of the simulations for the flowlines 624-626 from the second manifold 632 if the simulation for the flowline 623 finishes ahead of the simulation for the flowline 622. The results of the simulations for the flowlines 624-629 may yield the desired properties at or near the inlets of the points 661-666.

Attention is now directed to processing procedures, methods, techniques and workflows that are in accordance with some embodiments. Some operations in the processing procedures, methods, techniques and workflows disclosed herein may be combined and/or the order of some operations may be changed.

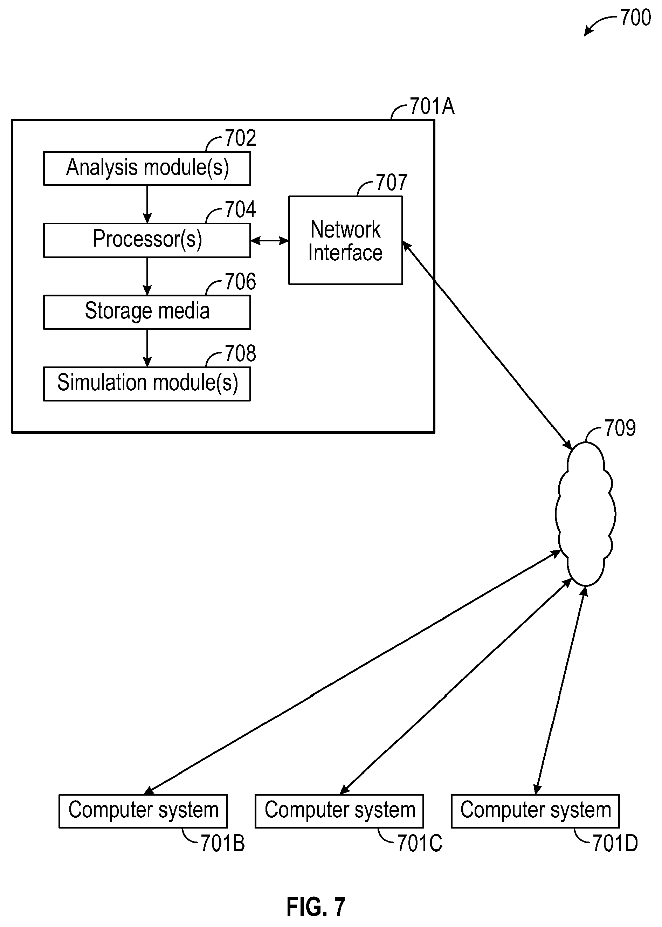

In some embodiments, the methods of the present disclosure may be executed by a computing system. Figure 7 illustrates an example of such a computing system 700, in accordance with some embodiments. The computing system 700 may include a computer or computer system 701A, which may be an individual computer system 701A or an arrangement of distributed computer systems. The computer system 701A includes one or more analysis modules 702 that are configured to perform various tasks according to some embodiments, such as one or more methods disclosed herein. To perform these various tasks, the analysis module 702 executes independently, or in coordination with, one or more processors 704, which is (or are) connected to one or more storage media 706A. The processor(s) 704 is (or are) also connected to a network interface 707 to allow the computer system 701A to communicate over a data network 709 with one or more additional computer systems and/or computing systems, such as 701B, 701C, and/or 701D (note that computer systems 701B, 701C and/or 701D may or may not share the same architecture as computer system 701A, and may be located in different physical locations, e.g., computer systems 701A and 701B may be located in a processing facility, while in communication with one or more computer systems such as 701C and/or 701D that are located in one or more data centers, and/or located in varying countries on different continents).

A processor can include a microprocessor, microcontroller, processor module or subsystem, programmable integrated circuit, programmable gate array, or another control or computing device.

The storage media 706 can be implemented as one or more computer-readable or machine-readable storage media. Note that while in the example embodiment of Figure 7 storage media 706 is depicted as within computer system 701A, in some embodiments, storage media 706 may be distributed within and/or across multiple internal and/or external enclosures of computing system 701 and/or additional computing systems. Storage media 706 may include one or more different forms of memory including semiconductor memory devices such as dynamic or static random access memories (DRAMs or SRAMs), erasable and programmable read-only memories (EPROMs), electrically erasable and programmable read-only memories (EEPROMs) and flash memories, magnetic disks such as fixed, floppy and removable disks, other magnetic media including tape, optical media such as compact disks (CDs) or digital video disks (DVDs), BLUERAY^{®} disks, or other types of optical storage, or other types of storage devices. Note that the instructions discussed above can be provided on one computer-readable or machine-readable storage medium, or in other embodiments, can be provided on multiple computer-readable or machine-readable storage media distributed in a large system having possibly plural nodes. Such computer-readable or machine-readable storage medium or media is (are) considered to be part of an article (or article of manufacture). An article or article of manufacture can refer to any manufactured single component or multiple components. The storage medium or media can be located either in the machine running the machine-readable instructions, or located at a remote site from which machine-readable instructions can be downloaded over a network for execution.

In some embodiments, computing system 700 contains two or more simulation modules 708 configured to run in parallel. It should be appreciated that computing system 700 is one example of a computing system, and that computing system 700 may have more or fewer components than shown, may combine additional components not depicted in the example embodiment of Figure 7, and/or computing system 700 may have a different configuration or arrangement of the components depicted in Figure 7. The various components shown in Figure 7 may be implemented in hardware, software, or a combination of both hardware and software, including one or more signal processing and/or application specific integrated circuits.

Further, aspects of the processing methods described herein may be implemented by running one or more functional modules in information processing apparatus such as general purpose processors or application specific chips, such as ASICs, FPGAs, PLDs, or other appropriate devices. These modules, combinations of these modules, and/or their combination with general hardware are all included within the scope of protection of the invention.

Fluid property simulations may be refined in an iterative fashion; this concept is applicable to the methods as discussed herein. This can include use of feedback loops executed on an algorithmic basis, such as at a computing device (e.g., computing system 700), and/or through manual control by a user who may make determinations regarding whether a given step, action, template, model, or set of curves has become sufficiently accurate for the evaluation of the fluid properties under consideration.

The foregoing description, for purpose of explanation, has been described with reference to specific embodiments. However, the illustrative discussions above are not intended to be exhaustive or to limit the invention to the precise forms disclosed. Many modifications and variations are possible in view of the above teachings. Moreover, the order in which the elements of the methods described herein are illustrate and described may be re-arranged, and/or two or more elements may occur simultaneously. The embodiments were chosen and described in order to explain the principals of the invention and its practical applications, to thereby enable others skilled in the art to utilize the invention and various embodiments with various modifications as are suited to the particular use contemplated. Additional information supporting the disclosure is contained in the appendix attached hereto.

## Claims

1. A method for simulating fluid properties in a production system, comprising:
receiving data from a sensor, the data representing a first property of a fluid that is measured by the sensor;
estimating a second property of the fluid based at least in part on the measured first property;
calculating a third property of the fluid using the estimated second property, wherein calculating the third property comprises:
running a first simulation on a first of a plurality of simulators; and
running a second simulation on a second of the plurality of simulators, wherein the first and second simulations at least partially overlap in the time domain; and
determining whether results of the first and second simulations converge to a common value.

2. The method of any of the preceding claims, further comprising placing the first and second simulations in a queue.

3. The method of claim 2, wherein the first and second simulations are loaded into the first and second simulators in an order in which the first and second simulations are placed in the queue.

4. The method of claim 2, wherein the first and second simulations are loaded into the first and second simulators simultaneously.

5. The method of claim 2, further comprising:
placing a third simulation in the queue;
determining whether one of the plurality of simulators is available to run the third simulation; and
running the third simulation on a next available simulator of the plurality of simulators when it is determined that one of the plurality of simulators is available.

6. The method of any of the preceding claims, further comprising modifying the estimate for the second property when the results for the first and second simulations do not converge to the common value.

7. The method of any of the preceding claims, further comprising adjusting a setting of a pump or a compressor in response to the results.

8. The method of any of the preceding claims, wherein the first property is selected from the group consisting of pressure, temperature, flow rate, and composition.

9. The method of claim 8, wherein the second property is selected from the group consisting of pressure, temperature, flow rate, and composition.

10. The method of claim 9, wherein the third property is selected from the group consisting of pressure, temperature, flow rate, and composition.

11. A non-transitory computer-readable medium storing instructions that, when executed by at least one processor of a computing system, cause the computing system to perform operations, the operations comprising:
receiving data from a sensor, the data representing a first property of a fluid in a first flowline;
estimating a second property of the fluid in the first flowline based at least in part on the measured first property;
calculating a third property of the fluid in the first flowline using the estimated second property, wherein calculating the third property comprises:
running a first simulation on a first of a plurality of simulators; and
running a second simulation on a second of the plurality of simulators, wherein the first and second simulations at least partially overlap in the time domain; and
determining whether results of the first and second simulations converge to a common value.

12. The non-transitory computer-readable medium of claim 11, wherein the operations further comprise using the results as a fourth property of the fluid in a second flowline.

13. The non-transitory computer-readable medium of claim 12, wherein the operations further comprise estimating a fifth property of the fluid in the second flowline using the fourth property.

14. The non-transitory computer-readable medium of claim 13, wherein the operations further comprise calculating a sixth property of the fluid in the second flowline using the estimated fifth property in the second flowline.

15. A computing system comprising:
one or more processors; and
a memory system comprising one or more non-transitory computer-readable media storing instructions that, when executed by at least one of the one or more processors, cause the computing system to perform operations, the operations comprising:
receiving data from a sensor, the data representing a first property of a fluid that is measured by the sensor;
estimating a second property of the fluid based at least in part on the measured first property;
calculating a third property of the fluid using the estimated second property, wherein calculating the third property comprises:
running a first simulation on a first of a plurality of simulators; and
running a second simulation on a second of the plurality of simulators, wherein the first and second simulations at least partially overlap in the time domain; and
determining whether results of the first and second simulations converge to a common value.
